# EUROPÄISCHE PATENTSCHRIFT

(11) **EP 0 856 737 B1**
(45) Veröffentlichungstag und Bekanntmachung des Hinweises auf die Patenterteilung: **18.09.2002**
(21) Anmeldenummer: 97811023.7
(22) Anmeldetag: 24.12.1997
(51) Int. Cl.: G01R 15/24

(54) **Magneto-optischer Stromsensor**
Magneto optical current sensor
Capteur de courant magnéto optique

(30) Priorität: 29.01.1997 DE 19703128
(43) Veröffentlichungstag der Anmeldung: 05.08.1998
(73) Patentinhaber: ABB RESEARCH LTD., 8050 Zürich (CH)
(72) Erfinder: Bohnert, Klaus, Dr., 5443 Niederrohrdorf (CH); Brändle, Hubert, Dr., 8102 Oberengstringen (CH); Schanke, Tone, 0380 Oslo (NO)
(74) Vertreter: ABB Patent Attorneys

(56) Entgegenhaltungen:
- EP-A- 0 477 415
- EP-A- 0 613 017
- US-A- 5 270 791
- FROSIO: "Reciprocal reflection interferometer for a fiber-optic Faraday current sensor" APPLIED OPTICS, Bd. 33, Nr. 25, 1.September 1994, WASHINGTON, DC,US, Seiten 6111-6121, XP000473296

## Beschreibung

### TECHNISCHES GEBIET

Bei der Erfindung wird ausgegangen von einem magnetooptischen Stromsensor nach dem Oberbegriff des Patentanspruchs 1.

### STAND DER TECHNIK

Die Erfindung nimmt auf einen Stand der Technik Bezug, wie er aus einer Veröffentlichung von K. Bohnert, H. Brändle und G. Frosio: FIELD TEST OF INTERFEROMETRIC OPTICAL FIBER HIGH-VOLTAGE AND CURRENT SENSORS, Tenth International Conference on OPTICAL FIBRE SENSORS, Glasgow, Scotland, 11 - 13 October 1994, S. 16 - 19, veröffentlicht durch SPIE-The International Society for Optical Engineering, Volume 2360, bekannt ist. Dort ist ein faseroptischer Stromsensor angegeben, bei dem Laserlicht über einen Faserkoppler und einen Faserpolarisator zu einem Y-Verzweiger gelangt, an dem es in 2 linear polarisierte Teilwellen aufgeteilt wird. Die 1. Welle läuft über einen Phasenmodulator, eine optische Glasfaser, welche die lineare Polarisation erhält, zu einer 1. λ/4-Faserschleife. In der Schleife wird die lineare in eine zirkulare Polarisation verwandelt. Das zirkular polarisierte Licht durchläuft eine faseroptische Sensorspule mit einem Durchmesser von 42 cm und 20 Windungen, die eine relativ geringe Doppelbrechung aufweist. Das aus der Sensorspule austretende, im Idealfall immer noch zirkular polarisierte Laserlicht wird in einer 2. λ/4-Faserschleife wieder in linear polarisiertes Licht zurückverwandelt und läuft über eine weitere polarisationserhaltende Glasfaser und den Phasenmodulator zum Y-Verzweiger zurück. Die 2. Teilwelle durchläuft den optischen Kreis mit den gleichen Polarisationszuständen in der entgegengesetzten Richtung. Im Y-Verzweiger werden beide zurückkehrenden Wellen zur Interferenz gebracht. Das resultierende Interferenzsignal gelangt über den Faserpolarisator und den Faserkoppler zu einer Photodiode. Das Magnetfeld des elektrischen Stroms, der von der Faserspule umschlossen wird, erzeugt eine optische Phasenverschiebung zwischen den beiden gegenläufigen Lichtwellen in der Spule. Die Phasenverschiebung wird als eine entsprechende Änderung des Interferenzsignals detektiert. Die biegeinduzierte, lineare Doppelbrechung der λ/4-Schleifen und damit die relative Phasenverzögerung sind temperaturabhängig. Ebenso ändert sich die lineare Doppelbrechung der Faserspule mit der Temperatur. Diese Effekte sind besonders bei tiefen Temperaturen stark ausgeprägt, weil sich hier gewöhnlich der Plastikschutzmantel der Faser verhärtet und zusätzliche Doppelbrechung erzeugt. Die Folge ist eine Veränderung der Meßempfindlichkeit des Sensors. Diese Effekte zeigen oft ein hystereseartiges Verhalten, so daß auch bei bekannter Temperatur eine exakte Korrektur dieses Signals kaum möglich ist.

In einem relativ eingeschränkten Temperaturbereich zwischen 0 °C und 70 °C ändert sich in dem beschriebenen Fall die relative Phasenverzögerung in der Sensorspule um ca. 7° und in der λ/4-Schleife um 4°. Bei einem Strom von 900 A und konstanter Temperatur betrug der relative Meßfehler ± 0,15 %.

Aus der DE-AS 2445369 ist ein magnetooptischer Meßwandler für Hochspannungsstrommessungen bekannt, bei dem die als Stromsensor verwendete Lichtleitfaser aus Glas mit einem Innendurchmesser von 57 µm einen Flüssigkern aus Hexachlorobuta-1,3-dien besitzt. Dadurch soll die bei Lichtleiterspulen aus Gradientenfasern stark temperaturabhängige Spannungsdoppelbrechung behoben werden.

Aus der DE 4304762 A1 ist ein Sensorkopf für eine faseroptische Strommeßvorrichtung mit einem polarimetrischen Detektionsverfahren, ohne λ/4-Verzögerungselemente, bekannt, bei der eine verdrillte, um einen Stromleiter geführte niedrigdoppelbrechende LB-Faser aus Quarzglas im Innern einer Kapillare aus Quarz mit einem Durchmesser im Bereich von 0,2 mm - 0,5 mm angeordnet und endseitig praktisch kräftefrei an aufgeschmolzenen Spleißstellen gehalten ist. Die durch ihre Verdrillung hervorgerufene Torsionsspannung der LB-Faser wird über die Spleißstellen und über Klebeverbindungen, welche Silikon enthalten, auf die Kapillare übertragen. Ein üblicherweise die Sensorfaser umgebender Plastikschutzmantel kann sich jedoch bei niedrigen Temperaturen verhärten und eine störende Doppelbrechung verursachen. Das in die Sensorfaser eingeleitete Licht wird nicht gegenläufig geführt, so daß sich der Einfluß externer Störeffekte auf die Sensorfaser nicht kompensiert.

EP 0 477 415 A1 offenbart einen optischen Stromwandler mit einem Sensorelement, welches einen Single-Mode-Wellenleiter beinhaltet, der in einem Substrat vergraben ist und als Sensorspule dient. Ein solcher Wellenleiter wird beispielsweise durch Austausch von Ionen in einem flächigen Substrat aus Glas erzeugt. Weil der Wellenleiter dadurch in ein festes Substrat integriert und somit sicher fixiert ist, werden mechanische Spannungen vermieden, und es wird auf diese Weise eine geringere Empfindlichkeit des Sensorelements gegenüber Umwelteinflüssen wie Temperaturschwankungen oder Vibrationen erreicht.

Die Merkmale des Oberbegriffs des Patentanspruchs 1 sind der Veröffentlichung von G. Frosio und R. Dändliker, Reciprocal reflection interferometer for a fiber-optic Faraday current sensor in: Applied Optics, Vol. 33, No. 25, 1. September 1994, S. 6111 - 6122, entnehmbar. Dort ist die Sensorspule endseitig verspiegelt. Dabei treten die gleichen Temperaturabhängigkeiten wie bei dem Stromsensor in dem eingangs genannten Konferenzbericht auf.

### DARSTELLUNG DER ERFINDUNG

Die Erfindung, wie sie im Patentanspruch 1 definiert ist, löst die Aufgabe, einen magnetooptischen Stromsensor der Oben genannten Art derart weiterzuentwickeln, daß dessen Temperaturabhängigkeit vernachlässigbar ist.

Vorteilhafte Ausgestaltungen der Erfindung sind in den abhängigen Patentansprüchen definiert.

Ein Vorteil der Erfindung besteht darin, daß eine aufwendige Temperaturkompensation oder -Korrektur entfallen kann.

### KURZE BESCHREIBUNG DER ZEICHNUNGEN

Die Erfindung wird nachstehend anhand von Ausführungsbeispielen erläutert. Es zeigen:
- Fig. 1: ein Sagnac-Interferometer mit λ/4-Verzögerungsgliedern und einer Stromsensorspule in einer Prinzipdarstellung,
- Fig. 2: eine Anordnung der Stromsensorspule gemäß Fig. 1 in einem Gehäuse,
- Fig. 3: Querschnitte von Glasfaserkernen und Lichtamplituden an einem Übergang von einer Zuleitungsfaser zu einem λ/4-Verzögerungsglied,
- Fig. 4: ein Sagnac-Interferometer mit einem λ/4-Verzögerungsglied und einer endseitig verspiegelten Stromsensorspule in einer Prinzipdarstellung und
- Fig. 5: die Temperaturabhängigkeit eines durch lineare Doppelbrechung verursachten Gangunterschiedes in einer getemperten Stromsensorspule.

### WEGE ZUR AUSFÜHRUNG DER ERFINDUNG

In den Figuren sind gleiche Teile mit gleichen Bezugszeichen gekennzeichnet.

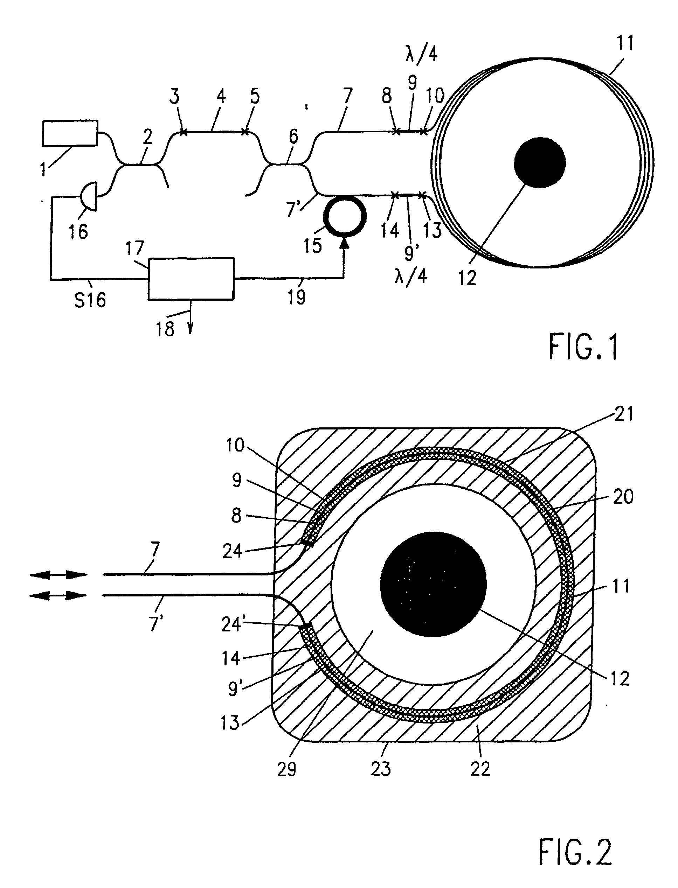

Fig. 1 zeigt ein Sagnac-Interferometer mit einer Lichtquelle bzw. einem Mehrmodenlaser (1), der Licht über einen 1. Faserkoppler (2), einen 1. Lichtfaserspleiß (3) zu einem Faserpolarisator (4) sendet. Das aus dem Faserpolarisator (4) austretende, linear polarisierte Licht gelangt über einen 2. Lichtfaserspleiß (5) zu einem 2. Faserkoppler (6), wo es in 2 Teilwellen zerlegt wird. Die 1. Teilwelle läuft über eine polarisationserhaltende optische Zuleitungsfaser (7) mit rundem oder vorzugsweise elliptischem Querschnitt des Faserkerns und einen 3. Lichtfaserspleiß (8) zu einem λ/4-Verzögerungsglied (9) aus einer weiteren optischen Lichtfaser mit einem stark elliptischen Querschnitt eines Faserkerns (31) mit einem typischen Hauptachsenverhältnis von 2 : 1. Aus diesem λ/4-Verzögerungsglied (9) tritt das Licht zirkular polarisiert über einen 4. Lichtfaserspleiß (10) in eine faseroptische Stromsensorspule (11) mit geringer linearer Doppelbrechung aus einem magnetooptisch aktiven Material, wie z. B. Quarzglas, ein, welche mehrere Windungen um einen Stromleiter (12) aufweist. Aus dieser Stromsensorspule (11) tritt das zirkular polarisierte Licht über einen 5. Lichtfaserspleiß (13) in ein 2. λ/4-Verzögerungsglied (9') ein, das gleich dem λ/4-Verzögerungsglied (9) ist. Aus diesem λ/4-Verzögerungsglied (9') austretendes Licht ist wieder linear polarisiert und gelangt über einen 6. Lichtfaserspleiß (14), über eine polarisationserhaltende optische Rückleitungsfaser (7') mit rundem oder vorzugsweise elliptischem Querschnitt des Faserkerns und über einen piezoelektrischen Modulator bzw. Phasenmodulator (15) zum 2. Faserkoppler (6) zurück. Die 2., am Faserkoppler (6) erzeugte Teilwelle durchläuft den optischen Kreis mit entsprechenden Polarisationszuständen in entgegengesetzter Richtung. Die beiden zurückkehrenden Wellen werden im 2. Faserkoppler (6) zur Interferenz gebracht. Das optische Interferenzsignal läuft über den 2. Lichtfaserspleiß (5), den Faserpolarisator (4), den 1. Lichtfaserspleiß (3) und den 1. Faserkoppler (2) zu einem Lichtdetektor bzw. einer Photodiode (16). Die Photodiode (16) liefert ausgangsseitig ein zur empfangenen Lichtintensität proportionales Lichtintensitätssignal (S16) einem Signalprozessor (17), der ausgangsseitig ein Stromsignal (18) als Meßergebnis zur Verfügung stellt und ferner ein Modulationssignal (19) an den Phasenmodulator (15) liefert. Dieses Modulationssignal (19) hat eine Frequenz im Bereich von oberhalb 100 kHz; es dient zur Einstellung des Arbeitspunktes des Sagnac-Interferometers. Vorzugsweise wird eine Phasenverschiebung von 90° eingestellt, entsprechend halber Maximalintensität, bei der eine mittels der Stromsensorspule (11) erfaßte Phasenverschiebung eine möglichst große Änderung des Lichtintensitätssignals (S16) bewirkt.

Die die optische Phasenverzögerung verursachende Doppelbrechung im λ/4-Verzögerungsglied (9, 9') ist durch die elliptische Form des Kernquerschnittes (31) bedingt. Da die Kernform temperaturunabhängig ist, ist ebenfalls die Phasenverzögerung temperaturunabhängig, d. h., das aus den λ/4-Verzögerungsgliedern (9, 9') austretende Licht ist, unabhängig von der Temperatur, stets zirkular polarisiert.

Verwendet man Zu- und Rückleitungsfasern (7, 7') mit einem runden Kern statt mit einem elliptischen, so muß die für die Polarisationserhaltung notwendige Doppelbrechung durch ein eingefrorenes, internes mechanisches Spannungsfeld erzeugt worden sein.

Fig. 2 zeigt ein um den Stromleiter (12) angeordnetes, innen hohles Sensorgehäuse (23), in welchem eine Stromsensorspule (11) mit einem Faserdurchmesser von etwa 80 µm mit nur einer Windung innerhalb eines Hohlraumes (21) einer kreisförmig gebogenen Kapillare (20) aus Quarzglas oder einer chromreichen Stahllegierung, wie z. B. Inconel, zwanglos, d. h. mechanisch spannungsfrei, gelagert ist. Der Stromleiter (12) ist dabei in einer zentralen Durchlaßöffnung (29) des Sensorgehäuses (23) angeordnet. Die Stromsensorfaser der Stromsensorspule (11) wird zunächst mit ihrem Schutzmantel mit Hilfe von Stickstoffgas unter hohem Druck in die Kapillare (20) hineingepreßt. Anschließend wird Alkohol in die Kapillare (20) gepreßt, der den Schutzmantel von der magnetooptischen Stromsensorfaser ablöst, so daß der Schutzmantel als Ganzes aus der Kapillare (20) gezogen werden kann, wobei die nackte Stromsensorfaser in der Kapillare (20) zurückbleibt. Die Stromsensorfaser der Stromsensorspule (11) wird nun vor dem Einbau in das Sensorgehäuse (23) in ihrem eingelegten und kreisförmig gekrümmten Zustand bei ihrer Erweichungstemperatur von etwa 830 °C während mehr als 3 h getempert, damit sie weitgehend frei von mechanischen Spannungen wird und somit wenigstens annähernd frei von linearer optischer Doppelbrechung ist. Nach dem Tempern und dem Anbringen der λ/4-Verzögerungsglieder (9, 9') sowie der Zu- und Rückleitungsfasern (7, 7') wird der Hohlraum (21) mit einem Schutzgas, vorzugsweise SF₆, gefüllt und durch Dichtungen (24, 24') z. B. aus Indium, Silber oder Gold gasdicht verschlossen, um zu verhindern, daß Feuchtigkeit und chemisch aggressive Dämpfe in das Innere der Kapillare (20) eindringen können. Innerhalb des Hohlraumes (21) sind auch die λ/4-Verzögerungsglieder (9) und (9') und Teile der optischen Zuleitungsfaser (7) sowie der Rückleitungsfaser (7') untergebracht. Die Kapillare (20) mit einem Innendurchmesser von einigen 100 µm ist in einer Vergußmasse, wie sie für elektronische Bauteile üblich ist, z. B. aus Polyurethan oder aus einem Silikonschaumstoff, eingebettet; sie dient als Schutz gegen störende mechanische und chemische Einflüsse.

Es versteht sich, daß die Stromsensorspule (11) mehrere Windungen, entsprechend Fig. 1, aufweisen kann. Anstelle eines Schutzgases könnte auch Öl oder Vakuum im Hohlraum (21) sein. Bei Verwendung von Öl kann die Kapillare (20) aus einem Kunststoff bestehen und nach dem Tempern über die Lichtfaser der Stromsensorspule (11) geschoben werden. Die Aufgabe der Dichtungen (24, 24') kann auch durch die Vergußmasse (22) übernommen werden, wenn diese dafür geeignet ist.

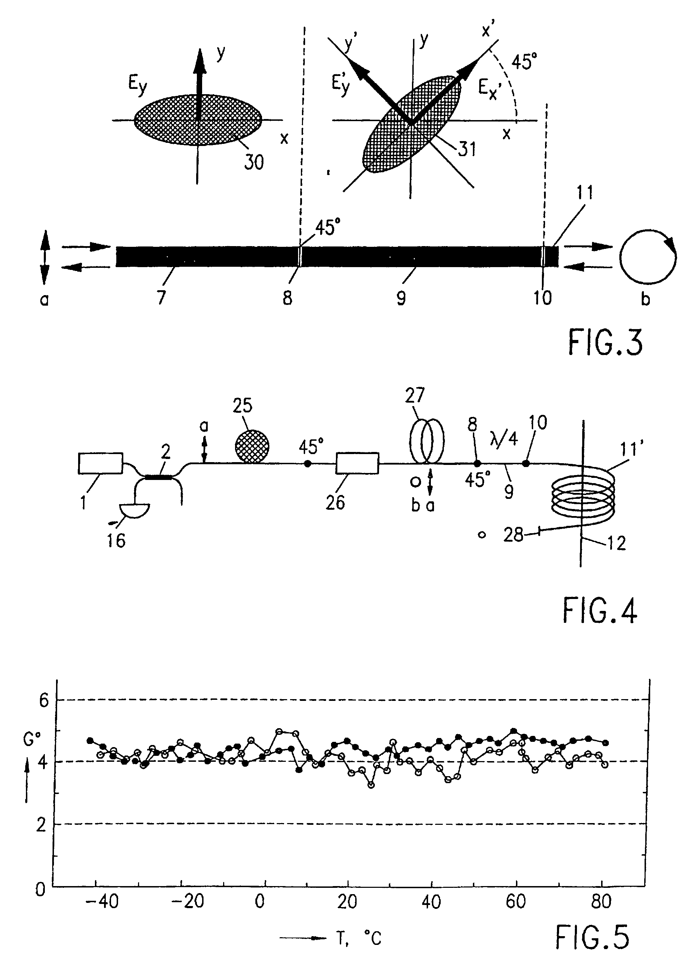

Fig. 3 zeigt das nichtgekrümmte, lineare λ/4-Verzögerungsglied (9), das über die Lichtfaserspleiße (8) und (10) mit der optischen Zuleitungsfaser (7) bzw. mit der Stromsensorspule (11) verbunden ist, unten in einem Längsschnitt und darüber in Querschnitten durch die entsprechenden Kerne (30) bzw. (31) der optischen Fasern (7) bzw. (9). Um den Faserkern (31) der optischen Faser (9) befindet sich ein Glasmantel; der üblicherweise noch darüber befindliche Plastikschutzmantel wurde entfernt.

Mit (x) und (y) sind zueinander orthogonale Koordinatenachsen der optischen Zuleitungsfaser (7) mit elliptischem Kernquerschnitt in Richtung von deren Haupt- und Nebenachse bezeichnet und mit (E_{y}) eine Lichtamplitude eines linear polarisierten Lichtes (a), das durch die optische Zuleitungsfaser (7) polarisationserhaltend z. B. in Richtung der y-Achse übertragen wird. Mit (x') und (y') sind zueinander orthogonale Koordinatenachsen der Lichtfaser des λ/4-Verzögerungsgliedes (9) mit elliptischem Kernquerschnitt (31) in Richtung von deren Haupt- und Nebenachse bezeichnet und mit (E_{x'}) und (E_{y'}) Lichtamplituden in Richtung der x'- bzw. y'-Achse. Die Achsen (x') und (y') der Lichtfaser des λ/4-Verzögerungsgliedes (9) sind gegenüber den Achsen (x) und (y) der optischen Zuleitungsfaser (7) um 45° ± ε gedreht, so daß das linear polarisierte Licht (a) beim Übergang von der optischen Zuleitungsfaser (7) in das λ/4-Verzögerungsglied (9) in 2 zueinander orthogonale Komponenten (E_{x'} und (E_{y'}) parallel zu den optischen Hauptachsen (x', y') des λ/4-Verzögerungsgliedes (9) zerlegt wird. Die beiden Polarisationskomponenten breiten sich mit unterschiedlicher Phasengeschwindigkeit aus. Die Länge des λ/4-Verzögerungsgliedes (9) wird so gewählt, daß die 2 Komponenten eine relative Phasenverzögerung von (2·m - 1) · 90° ± δ akkumulieren, wobei m eine ganze Zahl ist, so daß zirkular polarisiertes Licht aus dem λ/4-Verzögerungsglied (9) austritt. Die Ordnung m des λ/4-Verzögerungsgliedes (9) sollte vorzugsweise = 1 betragen, da die Temperaturabhängigkeit mit zunehmender Ordnung ansteigt. Für Licht mit einer Wellenlänge von 780 nm beträgt die Länge des λ/4-Verzögerungsgliedes (9), abhängig vom Fasertyp, für m = etwa 0,7 mm - 2 mm. Die Toleranzwinkel ε und δ sollen vorzugsweise < 5° bzw. < 10° sein; ε darf allenfalls 15° betragen und δ allenfalls 25°. Für ein λ/4-Verzögerungsglied (9) mit m = 1, das aus einer kommerziell erhältlichen Faser entnommen wurde, wurde für eine Lichtwellenlänge von 788 nm in einem Temperaturbereich zwischen - 40 °C und 80 °C eine tolerierbare Änderung (Abnahme) der phasenverzögerung um 1,8° gemessen. Diese verbleibende Temperaturabhängigkeit des λ/4-Verzögerungsgliedes (9) rührt u. a. von mechanischen Spannungen zwischen dessen Faserkern und Fasermantel (nicht dargestellt) her. Diese mechanischen Spannungen könnten noch durch eine Bestrahlung der Lichtfaser (9) mit ultraviolettem Licht und/oder durch eine Temperung bei einer Temperatur oberhalb von 200 °C reduziert werden, was aber für die praktische Anwendung nicht notwendig ist.

Die Ausführung des λ/4-Verzögerungsgliedes (9') stimmt mit derjenigen des λ/4-Verzögerungsgliedes (9) überein. Die optischen Hauptachsen (x', y') der Verzögerungselemente (9) und (9') können bezüglich der Ebene der Stromsensorspule (11), deren Faserkern einen runden Querschnitt hat, beliebig ausgerichtet sein. Wichtig ist, daß die optischen Hauptachsen (x', y') der λ/4-Verzögerungsglieder (9, 9') mit den optischen Hauptachsen (x, y) der Zuleitungsfaser (7) und der Rückleitungsfaser (7') einen Winkel von 45° ± ε oder - 45° ± ε bilden, wobei ε ein vorgebbarer Toleranzwinkel von < 15°, vorzugsweise von < 5° ist. Die Länge des faseroptischen λ/4-Verzögerungsgliedes (9, 9') ist so zu wählen, daß die Polarisationskomponenten parallel zu den optischen Hauptachsen (x', y') in den λ/4-Verzögerungsgliedern (9, 9') einen Phasenunterschied von (2·m - 1) · 90° ± δ akkumulieren, wobei m eine ganze Zahl und δ ein vorgebbarer Toleranzwinkel von < 25°, vorzugsweise von < 10° ist.

Fig. 4 zeigt eine andere Ausführungsform eines Sagnac-Interferometers mit einem λ/4-Verzögerungsglied (9) gemäß den Fig. 1 - 3 und einer endseitig verspiegelten Stromsensorspule (11'), die in gleicher Weise gelagert und getempert ist wie die in Verbindung mit Fig. 1 und 2 beschriebene Stromsensorspule (11). Licht gelangt von dem Mehrmodenlaser (1) über den Faserkoppler (2) zu einem Faserpolarisator (25). Nach dem Faserpolarisator (25) wird das Licht an einem 45°-Spleiß in 2 orthogonale Polarisationszustände aufgespaltet, die sich entlang der beiden Hauptachsen einer polarisationserhaltenden (stark doppelbrechenden) Lichtfaser (27) ausbreiten, an deren Anfang sich ein Phasenmodulator (26) befindet. Die beiden linearen, orthogonalen Polarisationszustände werden in dem λ/4-Verzögerungsglied (9) in 2 zirkulare Polarisationszustände mit gegenläufigem Drehsinn (links- und rechtszirkular polarisierte Wellen) verwandelt, welche einer Stromsensorspule (11') zugeführt werden. Nach Durchlaufen dieser Stromsensorspule (11') werden diese Lichtwellen an einer endseitigen Verspiegelung (28) reflektiert und laufen mit getauschten Polarisationszuständen zum Faserpolarisator (25) zurück, wo sie zur Interferenz gebracht werden. Die Interferenzintensität wird mit der Photodiode (16) gemessen. Der Faserpolarisator (25) kann gleich aufgebaut sein wie der Faserpolarisator (4) gemäß Fig. 1 und der Phasenmodulator (26) gleich wie der dortige Phasenmodulator (15). Die stark doppelbrechende optische Lichtfaser (27) ist so lang, daß darin die Kohärenz der beiden orthogonalen Polarisationszustände verlorengeht.

Wichtig ist, daß die Stromsensorspulen (11) und (11') und vorzugsweise auch die λ/4-Verzögerungsglieder (9) und (9') wenigstens annähernd frei von mechanischen Spannungen und somit formstabil sind, so daß sie bezüglich ihrer Übertragungseigenschaften für Licht zumindest in dem vorgesehenen Anwendungsbereich nahezu temperaturunabhängig sind. Die Stromsensorfasern der Stromsensorspulen (11) und (11') behalten ihre gebogene Gestalt bei, wenn sie von den λ/4-Verzögerungsgliedern (9, 9') und den Zu- und Rückleitungsfasern (7, 7') getrennt würden. Ein doppelbrechungsinduzierter Gangunterschied (G), vgl. Fig. 5, soll < 20°, vorzugsweise < 10° sein.

Wichtig ist ferner, daß 2 Lichtwellen durch die Stromsensorfasern der Stromsensorspule (11, 11') geführt werden, da dadurch Störeffekte, wie sie z. B. durch mechanische Vibrationen hervorgerufen werden, teilweise kompensiert werden können.

Fig. 5 zeigt die Temperaturabhängigkeit eines durch die nach dem Tempern noch verbleibende lineare Doppelbrechung verursachten Gangunterschiedes (G) in Grad bei einer Stromsensorspule (11) mit 7 Windungen und einem Durchmesser von 11,7 cm. Auf der Abszisse ist die Temperatur (T) in °C aufgetragen. Die bei ansteigender Temperatur (T) gemessenen Werte des Gangunterschiedes (G) sind durch Kreise, die bei abnehmender Temperatur (T) gemessenen durch Punkte dargestellt. Ohne Temperung der Stromsensorfaser betrug der gemessene, spannungsinduzierte Gangunterschied (G) etwa 80° (nicht dargestellt). Durch das thermische Ausheilen der mechanischen Spannungen in der Stromsensorfaser ließ sich der Gangunterschied (G) auf einen fast temperaturunabhängigen Wert von 4° reduzieren, der so klein ist, daß er die Sensorgenauigkeit nicht beeinträchtigt.

### BEZEICHNUNGSLISTE

- 1: Lichtquelle, Mehrmodenlaser
- 2, 6: Faserkoppler
- 4, 25: Faserpolarisatoren
- 3, 5, 8, 10, 13, 14: Lichtfaserspleiße, Glasfaserverbindungen
- 7: optische Zuleitungsfaser mit elliptischem Kernquerschnitt 30
- 7': optische Rückleitungsfaser mit elliptischem Kernquerschnitt
- 9, 9': λ/4-Verzögerungsglieder, optische Fasern mit elliptischem Kernquerschnitt 31, Einmodenfasern
- 11: faseroptische Stromsensorspule mit magnetooptischer Stromsensorfaser
- 11': endseitig verspiegelte Stromsensorspule
- 12: Stromleiter
- 15, 26: Phasenmodulatoren, piezoelektrische Modulatoren
- 16: Lichtdetektor, Photodiode
- 17: Signalprozessor
- 18: Stromsignal
- 19: Modulationssignal
- 20: Kapillare
- 21: Hohlraum von 20
- 22: Polyurethan, Silikonschaumstoff, Vergußmasse
- 23: Sensorgehäuse
- 24, 24': Dichtungen von 20
- 27: stark doppelbrechende optische Faser
- 28: Spiegel, Verspiegelung
- 29: zentrale Durchlaßöffnung von 23
- 30: Kernquerschnitt von 7
- 31: Kernquerschnitt von 9
- a: linar polarisiertes Licht
- b: zirkular polarisiertes Licht
- E_{x'}, E_{y}, K_{y'}: Lichtamplitude in Richtung der x'-, y-, y'-Achse
- G: Gangunterschied
- S16: Lichtintensitätssignal
- T: Temperatur
- x, x'; y, y': Koordinatenachsen

## Patentansprüche

1. Magnetooptischer Stromsensor
a) mit einem λ/4-Verzögerungsglied (9, 9'),
b) welches einerseits mit einem ersten Ende einer Stromsensorspule (11, 11') mit einer magnetooptischen Stromsensorfaser in optischer Verbindung steht,
c) durch welche zirkular polarisiertes Licht gegenläufig geführt ist, und
d) welches λ/4-Verzögerungsglied (9, 9') andererseits mit einer polarisationserhaltenden Zu- oder Rückleitungsfaser (7, 7'; 27) mit zueinander orthogonalen Hauptachsen (x, y) der Doppelbrechung in optischer Verbindung steht,
e) wobei die optischen Hauptachsen (x', y') des λ/4-Verzögerungsgliedes (9, 9') mit den optischen Hauptachsen (x, y) der Zu- oder Rückleitungsfaser (7, 7; 27) einen toleranzbehafteten Winkel von 45° oder -45° bilden,
**dadurch gekennzeichnet**,
f) daß die Stromsensorfaser der Stromsensorspule (11, 11') ohne Schutzmantel in einer Kapillare (20) gelagert ist,
g) daß diese Stromsensorfaser wenigstens annähernd frei von einer mechanischen Spannung ist,
h) daß das λ/4-Verzögerungsglied (9, 9') eine wenigstens annähernd mechanisch spannungsfreie Einmodenfaser mit elliptischem Kernquerschnitt (31) ist,
i) daß die Toleranz des toleranzehafteten Winkels ± ε beträgt, wobei ε ein vorgebbarer Toleranzwinkel ist, und
j) daß die Länge des λ/4-Verzögerungsgliedes (9, 9') so gewählt ist, daß die Polarisationskomponenten parallel zu den optischen Hauptachsen (x', y') in dem λ/4-Verzögerungsglied (9, 9') einen Phasenunterschied von (2·m - 1) · 90° ± δ akkumulieren, wobei m eine ganze Zahl und δ ein vorgebbarer Toleranzwinkel ist.

2. Magnetooptischer Stromsensor nach Anspruch 1, **dadurch gekennzeichnet, daß** der vorgebbare Toleranzwinkel ε < 15° ist.

3. Magnetooptischer Stromsensor nach Anspruch 2, **dadurch gekennzeichnet, daß** der vorgebbare Toleranzwinkel ε < 5° ist.

4. Magnetooptischer Stromsensor nach einem der vorhergehenden Ansprüche, **dadurch gekennzeichnet, daß** der vorgebbare Toleranzwinkel δ < 25° ist.

5. Magnetooptischer Stromsensor nach Anspruch 4, **dadurch gekennzeichnet, daß** der vorgebbare Toleranzwinkel δ < 10° ist.

6. Magnetooptischer Stromsensor nach einem der vorhergehenden Ansprüche, **dadurch gekennzeichnet, daß** die Kapillare (20) gasdicht verschlossen ist und Vakuum oder ein Schutzgas zum Schutz der Stromsensorfaser der Stromsensorspule (11, 11') vor Feuchtigkeit und/oder chemisch aggressiven Gasen enthält.

7. Magnetooptischer Stromsensor nach einem der vorhergehenden Ansprüche, **dadurch gekennzeichnet, daß** auch das λ/4-Verzögerungsglied (9, 9') in der Kapillare (20) gelagert ist.

8. Magnetooptischer Stromsensor nach einem der vorhergehenden Ansprüche, **dadurch gekennzeichnet, dass**
a) der magnetooptische Stromsensor ein zweites λ/4-Verzögerungsglied (9, 9') beinhaltet,
b) welches einerseits mit dem zweiten Ende der Stromsensorspule (11, 11') in optischer Verbindung steht, und
c) welches andererseits mit einer zweiten polarisationserhaltenden Zu- oder Rückleitungsfaser (7, 7') mit zueinander orthogonalen Hauptachsen (x, y) der Doppelbrechung in optischer Verbindung steht,
d) wobei das zweite λ/4-Verzögerungsglied (9, 9') eine wenigstens annähernd mechanisch spannungsfreie Einmodenfaser mit elliptischem Kernquerschnitt (31) ist, und
e) wobei die optischen Hauptachsen (x', y') des zweiten λ/4-Verzögerungsgliedes (9, 9') mit den optischen Hauptachsen (x, y) der zweiten Zu- oder Rückleitungsfaser (7, 7') einen Winkel von 45° ± ε oder -45° ± ε bilden, und
f) wobei das zweite λ/4-Verzögerungsglied (9, 9') eine Länge aufweist, die so gewählt ist, daß die Polarisationskomponenten parallel zu den optischen Hauptachsen (x', y') des zweiten λ/4-Verzögerungsgliedes (9, 9') in dem zweiten λ/4- Verzögerungsglied (9, 9') einen Phasenunterschied von (2·m - 1)·90° ± δ akkumulieren.

9. Magnetooptischer Stromsensor nach Anspruch 8, **dadurch gekennzeichnet,**
**dass** das zweite λ/4-Verzögerungsglied (9, 9') in der Kapillare (20) gelagert ist.

10. Magnetooptischer Stromsensor nach einem der vorhergehenden Ansprüche, **dadurch gekennzeichnet, daß** die lineare optische Doppelbrechung in der Stromsensorspule (11, 11') ± 20° nicht überschreitet.

11. Magnetooptischer Stromsensor nach einem der vorhergehenden Ansprüche, **dadurch gekennzeichnet, daß** die lineare optische Doppelbrechung in der Stromsensorspule (11, 11') ± 10° nicht überschreitet.

## Claims

1. Magneto-optic current sensor
a) comprising a λ/4 retardation element (9, 9'),
b) which on the one hand is optically connected to a first end of a current-sensing coil (11, 11') with a magneto-optic current sensor fibre,
c) through which circularly polarized light is guided in an oppositely directed fashion, and
d) which λ/4 retardation element (9, 9') on the other hand is optically connected to a polarization-maintaining feed- or return-fibre (7, 7'; 27) with mutually orthogonal principal axes (x, y) of birefringence,
e) wherein the optical principal axes (x', y') of the λ/4 retardation element (9, 9') form with the optical principal axes (x, y) of the feed- or return-fibre (7, 7'; 27) a tolerance-affected angle of 45° or -45°,
**characterized**
f) in that the current sensor fibre of the current-sensing coil (11, 11') is embedded without a protective cladding in a capillary (20),
g) in that this current sensor fibre is at least approximately free from a mechanical strain,
h) in that the λ/4 retardation element (9, 9') is an at least approximately mechanically strain-free single-mode fibre with an elliptical core cross section (31),
i) in that the tolerance of the tolerance-affected angle is ± ε, ε being a prescribable tolerance angle, and
j) in that the length of the λ/4 retardation element (9, 9') is selected such that the polarization components parallel to the optical principal axes (x', y') accumulate in the λ/4 retardation element (9, 9') a phase difference of (2·m - 1) · 90° ± δ, m being an integer and δ being a prescribable tolerance angle.

2. Magneto-optic current sensor according to Claim 1, **characterized in that** the prescribable tolerance angle ε < 15°.

3. Magneto-optic current sensor according to Claim 2, **characterized in that** the prescribable tolerance angle ε < 5°.

4. Magneto-optic current sensor according to one of the preceding claims, **characterized in that** the prescribable tolerance angle δ < 25°.

5. Magneto-optic current sensor according to Claim 4, **characterized in that** the prescribable tolerance angle δ < 10°.

6. Magneto-optic current sensor according to one of the preceding claims, **characterized in that** the capillary (20) is sealed in a gas-tight manner and contains a vacuum or a protective gas for protection of the current sensor fibre of the current-sensing coil (11, 11') against humidity and/or chemically aggressive gases.

7. Magneto-optic current sensor according to one of the preceding claims, **characterized in that** also the λ/4 retardation element (9, 9') is embedded in the capillary (20).

8. Magneto-optic current sensor according to one of the preceding claims, **characterized in that**
a) the magneto-optic current sensor includes a second λ/4 retardation element (9, 9'),
b) which on the one hand is optically connected to the second end of the current-sensing coil (11, 11'), and
c) which on the other hand is optically connected to a second polarization-maintaining feed- or return-fibre (7, 7') with mutually orthogonal principal axes (x, y) of birefringence,
d) wherein the second λ/4 retardation element (9, 9') is an at least approximately mechanically strain-free single-mode fibre with an elliptical core cross section (31), and
e) wherein the optical principal axes (x', y') of the second λ/4 retardation element (9, 9') form with the optical principal axes (x, y) of the second feed- or return-fibre (7, 7') an angle of 45° ± ε or -45° ± ε, and
f) wherein the second λ/4 retardation element (9, 9') has a length which is selected such that the polarization components parallel to the optical principal axes (x', y') of the second λ/4 retardation element (9, 9') accumulate a phase difference of (2·m - 1) · 90° ± δ in the second λ/4 retardation element (9, 9').

9. Magneto-optic current sensor according to Claim 8, **characterized in that** the second λ/4 retardation element (9, 9') is embedded in the capillary (20).

10. Magneto-optic current sensor according to one of the preceding claims, **characterized in that** the linear optical birefringence in the current-sensing coil (11, 11') does not exceed ± 20°.

11. Magneto-optic current sensor according to one of the preceding claims, **characterized in that** the linear optical birefringence in the current-sensing coil (11, 11') does not exceed ± 10°.

## Revendications

1. Capteur de courant magnéto-optique
a) comprenant un élément à retard λ/4 (9, 9'),
b) qui d'une part est connecté optiquement, à une première extrémité d'une bobine de capteur de courant (11, 11'), à une fibre de capteur de courant magnéto-optique,
c) au travers de laquelle de la lumière polarisée circulairement est guidée en sens contraire, et
d) lequel élément à retard λ/4 (9, 9') d'autre part étant connecté optiquement à une fibre de conduite d'amenée ou de retour (7, 7'; 27) recevant la polarisation avec des axes principaux orthogonaux (x, y) de biréfringence,
e) les axes principaux optiques (x', y') de l'élément à retard λ/4 (9, 9') formant avec les axes principaux optiques (x, y) de la fibre de conduite d'amenée ou de retour (7, 7'; 27) un angle de 45° ou de - 45° soumis à des tolérances,
**caractérisé en ce que**
f) la fibre de capteur de courant de la bobine de capteur de courant (11, 11') est logée sans gaine de protection dans un capillaire (20),
g) cette fibre de capteur de courant est au moins approximativement exempte de contrainte mécanique,
h) l'élément à retard λ/4 (9, 9') est une fibre monomode au moins approximativement exempte de contrainte mécanique avec une section transversale de noyau elliptique (31),
i) la tolérance de l'angle soumis à des tolérances est de ± ε, où ε est un angle de tolérance prédéfinissable, et
j) la longueur de l'élément à retard λ/4 (9, 9') est choisie de telle sorte que les composantes de polarisation parallèlement aux axes principaux optiques (x', y') accumulent dans l'élément à retard λ/4 (9, 9') une différence de phase de (2·m - 1) · 90° ± δ, où m est un nombre entier et δ est un angle de tolérance prédéfinissable.

2. Capteur de courant magnéto-optique selon la revendication 1, **caractérisé en ce que** l'angle de tolérance prédéfinissable ε < 15°.

3. Capteur de courant magnéto-optique selon la revendication 2, **caractérisé en ce que** l'angle de tolérance prédéfinissable ε < 5°.

4. Capteur de courant magnéto-optique selon l'une quelconque des revendications précédentes, **caractérisé en ce que** l'angle de tolérance prédéfinissable δ < 25°.

5. Capteur de courant magnéto-optique selon la revendication 4, **caractérisé en ce que** l'angle de tolérance prédéfinissable δ < 10°.

6. Capteur de courant magnéto-optique selon l'une quelconque des revendications précédentes, **caractérisé en ce que** le capillaire (20) est fermé de manière étanche aux gaz et contient du vide ou un gaz protecteur pour la protection de la fibre de capteur de courant de la bobine de capteur de courant (11, 11') contre l'humidité et/ou des gaz chimiquement agressifs.

7. Capteur de courant magnéto-optique selon l'une quelconque des revendications précédentes, **caractérisé en ce que** l'élément à retard λ/4 (9, 9') est aussi logé dans le capillaire (20).

8. Capteur de courant magnéto-optique selon l'une quelconque des revendications précédentes, **caractérisé en ce que**
a) le capteur de courant magnéto-optique contient un deuxième élément à retard λ/4 (9, 9'),
b) qui d'une part est connecté optiquement à la deuxième extrémité de la bobine de capteur de courant (11, 11') et
c) qui d'autre part est connecté optiquement à une deuxième fibre de conduite d'amenée ou de retour (7, 7') recevant la polarisation avec des axes principaux orthogonaux (x, y) de biréfringence,
d) le deuxième élément à retard λ/4 (9, 9') étant une fibre monomode au moins approximativement exempte de contrainte mécanique avec une section transversale de noyau elliptique (31), et
e) les axes principaux optiques (x', y') du deuxième élément à retard λ/4 (9, 9') formant avec les axes principaux optiques (x, y) de la deuxième fibre de conduite d'amenée ou de retour (7, 7') un angle de 45° ± ε ou de -45° ± ε, et
f) le deuxième élément à retard λ/4 (9, 9') présentant une longueur qui est choisie de telle sorte que les composantes de polarisation parallèlement aux axes principaux optiques (x', y') du deuxième élément à retard λ/4 (9, 9') accumulent dans le deuxième élément à retard λ/4 (9, 9') une différence de phase de (2·m - 1) · 90° ± δ.

9. Capteur de courant magnéto-optique selon la revendication 8, **caractérisé en ce que** le deuxième élément à retard λ/4 (9, 9') est logé dans le capillaire (20).

10. Capteur de courant magnéto-optique selon l'une quelconque des revendications précédentes, **caractérisé en ce que** la biréfringence optique linéaire dans la bobine du capteur de courant (11, 11') ne dépasse pas ± 20°.

11. Capteur de courant magnéto-optique selon l'une quelconque des revendications précédentes, **caractérisé en ce que** la biréfringence optique linéaire dans la bobine du capteur de courant (11, 11') ne dépasse pas ± 10°.
